# EUROPEAN PATENT SPECIFICATION

(11) **EP 3 466 559 B1**
(45) Date of publication and mention of the grant of the patent: **22.06.2022**
(21) Application number: 17806229.5
(22) Date of filing: 21.04.2017
(51) Int. Cl.: B21J 5/02, H01L 23/36, B21C 23/06, B21C 23/18, B21J 5/12, B21J 13/02, B21K 23/00, F28F 3/02, F28F 3/04, H01L 21/48, H01L 23/367

(54) **FORGING DEVICE AND FORGING METHOD**
SCHMIEDEVORRICHTUNG UND SCHMIEDEVERFAHREN
DISPOSITIF ET METHODE DE FORGEAGE

(30) Priority: 03.06.2016 JP 2016111479
(43) Date of publication of application: 10.04.2019
(73) Proprietor: Showa Denko K.K., Tokyo 105-8518 (JP)
(72) Inventor: IGARASHI Kazuo, Kitakata-shi Fukushima 966-0845 (JP)
(74) Representative: Hoffmann Eitle
(86) International application number: PCT/JP2017/016021
(87) International publication number: WO 2017/208669

(56) References cited:
- CN-U- 201 684 773
- JP-A- H0 857 573
- JP-A- H0 857 573
- JP-A- S5 112 370
- JP-A- 2010 074 024
- JP-A- 2015 050 318
- JP-A- 2015 050 318

## Description

### Technical Field

The present invention relates to a forging device and a forging method for producing a forged product in which a plurality of protrusions, such as, e.g., fins, is formed on a base plate.

### Background Art

In the case of producing a heat sink having a large number of fins formed on a front surface or a rear surface of a base plate by die forging, for example, a semi-sealed forging device (dies) as shown in JP 2015-50318 A related to the preamble of claims 1 and 6 is used.

A forging device for molding a heat sink is provided with a die (lower die) and a punch (upper die), and for example, a number of fin molding cavities for molding fins are formed in the bottom surface of the molding hole of the die. When a punch is driven into a molding hole of a die in which a forging material is set, the forging material is pressurized and plastically flows, so the metallic material (metal) as a forging material is filled in the fin molding cavities and fins are molded. Further, the metal is also filled in the burr molding portion between the molding hole inner peripheral side surface of the die and the outer peripheral side surface of the punch, and burrs are molded. Furthermore, a base plate is molded by the metal present in the base plate molding portion between the molding hole bottom surface of the die and the pressing surface of the punch.

JP H08 57573 A, CN 201 684 773 U and JP S5112370 A constitute further prior art.

### SUMMARY OF THE INVENTION

### Problems to be Solved by the Invention

In the aforementioned conventional forging process, during the molding process, the metal is split by a split flow forging effect into a metal flowing inward and a metal flowing outward. The metal flowing inward flows into the fin molding cavities of the inner peripheral portion, while the metal flowing outward flows into the fin molding cavities of the outer peripheral portion and the burr molding portion. However, as a result of the analysis of the flow of the metal (metal flow), it was found the fact that at the initial stage of pressurization, the metal flowing outward will not be smoothly discharged from the base plate molding portion to the burr molding portion, which makes it difficult to reduce the height dimension (thickness) of the base plate molding portion. Furthermore, at the stage immediately before completion of the pressurization, the flow amount of the metal decreases and the amount of the metal to be filled in the fin forming cavities of the outer peripheral portion becomes insufficient, which may cause a risk of causing underfill.

As described above, in the conventional forging process, there were problems that it was difficult to reduce the thickness of the base plate, so a lightweight and compact heat sink could not be produced. Further, the fin height of a heat sink could not be made uniform due to the underfill, so a high quality forged product (heat sink) could not be produced.

Preferred embodiments of the present invention have been made in view of the above-mentioned and/or other problems in the related art. The preferred embodiments of the present invention can significantly improve upon existing methods and/or apparatuses.

The present invention has been made in view of the aforementioned problems, and aims to provide a forging device and a forging method capable of producing a forged product excellent in dimensional accuracy of a protrusion height, such as, e.g., a fin height, and also capable of making the base plate thin to reduce in size and weight.

The other purposes and advantages of the present invention will be made apparent from the following preferred embodiments.

### Means for Solving the Problems

In order to solve the aforementioned problems, the present invention provides a forging device according to claim 1 and a forging method according to claim 6.

Preferably, a chamfered portion is formed at an internal corner portion between the inner peripheral side surface and the bottom surface of the molding hole.

According to the invention, the tip end portion outer peripheral side surface of the punch is formed by an inclined surface which is inclined with respect to the axis and approaches the axis toward the pressing direction of the punch, and an inclination angle of the end portion outer peripheral side surface of the punch with respect to the axis is formed to be less than an inclination angle of the inner peripheral side surface of the molding hole with respect to the axis.

Preferably, a chamfered portion is formed at an external corner portion between the tip end portion outer peripheral side surface and the tip end surface of the punch.

Preferably, an external corner portion between the tip end portion outer peripheral side surface and the tip end surface of the punch is arranged at a position closer to the axis than the internal corner portion between the inner peripheral side surface and the bottom surface of the molding hole.

Preferably, the protrusion molding cavity is constituted by a fin molding cavity for molding a fin of a heat sink.

According to the forging device of the invention the molding hole inner peripheral side surface of the die is formed in an inclined surface that approaches the axis toward the pressing direction of the punch. Therefore, as the punch is moved downward in accordance with the progress of the molding, the width of the burr molding portion inlet on the way from the base plate molding portion to the burr molding portion gradually narrows. Therefore, at the initial stage of pressurization, since the width of the burr molding portion inlet is wide, the metal flowing outward due to the split flow forging effect preferentially flows to the burr molding portion, so that the vertical dimension (thickness) of the base plate molding portion can be formed as thin as desired. Further, at the stage of the pressurization end, the width of the burr molding portion inlet becomes narrow and therefore the flow of the metal to the burr molding portion is suppressed. As a result, the metal is fully filled in all of the protrusion molding cavities of the outer peripheral portion. Thus, it is possible to effectively prevent occurrence of underfill. In this way, the base plate of the forged product can be made thin, and the forged product can be reduced in weight and size. Further, the height accuracy of the protrusion can be improved, so a high quality forged product can be produced.

Since the molding hole inner peripheral surface is formed in the inclined surface, the releasability when discharging the forged roughly shaped material from the molding hole can be improved, enabling a smooth forging process operation, which in turn can improve the production efficiency.

According to a preferred embodiment of the forging device since the chamfered portion is formed at the internal corner portion of the molding hole in the die, it is possible to avoid concentration of the stress on the internal corner portion of the die at the time of molding. Thus, occurrence of cracks, etc., of the internal corner portion can be effectively prevented, which can improve the die life. This in turn can improve the durability. Further, during the molding, the metal from the base plate molding portion to the burr molding portion can flow smoothly, so that the punch load can be reduced correspondingly, and therefore the device itself can be reduced in size.

According to the forging device of the invention , since the tip end portion outer peripheral side surface of the punch is formed in an inclined surface that approaches the axis toward the pressing direction, it is possible to improve the releasability at the time of separating the punch from the forged roughly shaped material. Thus, the forging process operation can be carried out more smoothly, so that the production efficiency can be further improved.

According to a preferred embodiment of the forging device since the chamfered portion is formed at the external corner portion of the punch, it is possible to avoid concentration of the stress during molding on the external corner portion of the punch. Thus, occurrence of cracks, etc., of the external corner portion can be prevented effectively, which can improve the die life. This in turn can further improve the durability. Further, during the molding, the metal can more smoothly flow from the base plate molding portion to the burr molding portion, so that the punch load can be reduced correspondingly, and the device itself can be more assuredly reduced in size.

According to a preferred embodiment of the forging device , since the external corner portion of the punch is arranged inner than the internal corner portion of the molding hole, it is possible to more assuredly prevent the external corner portion of the punch from coming into contact with the inner peripheral side surface of the molding hole, which in turn can more assuredly prevent breakage, etc., of the due to the contact.

According to a preferred embodiment of the forging device it is possible to produce a heat sink in which a fin is formed on the base plate.

According to a preferred embodiment of the forging method in the same manner as described above, it is possible to produce a high quality forged product reduced in weight and size and excellent in height accuracy of the protrusion.

### BRIEF DESCRIPTION OF THE DRAWINGS

FIG. 1A is a cross-sectional view showing a state immediately before initiation of molding in a forging device according to a first embodiment not being part of the present invention.
FIG. 1B is a cross-sectional view showing a state immediately after initiation of pressurization in a forging device according to the first embodiment.
FIG. 1C is a cross-sectional view showing a state immediately before completion of pressurization in the forging device of the first embodiment.
FIG. 1D is a cross-sectional view showing a state immediately after initiation of punch rising in the forging device of the first embodiment.
FIG. 1E is a cross-sectional view showing a state immediately after discharge initiation of a forged roughly shaped material in the first embodiment forging device.
FIG. 2 is a perspective view showing a heat sink produced based on a forging device of the first embodiment.
FIG. 3A is a cross-sectional view showing a state immediately before initiation of molding in a forging device according to a second embodiment not being part of the present invention.
FIG. 3B is a cross-sectional view showing a state immediately before completion of pressurization in the forging device of the second embodiment.
FIG. 4A is a cross-sectional view showing a state immediately before completion of pressurization in a forging device according to a third embodiment, which is part of the present invention.
FIG. 4B is a cross-sectional view showing a state immediately after initiation of punch rising in the forging device of the third embodiment.
FIG. 5A is a cross-sectional view showing a state immediately before completion of pressurization in a conventional forging device.
FIG. 5B is a cross-sectional view showing a state immediately after initiation of punch rising in a conventional embodiment forging device.
FIG. 5C is a cross-sectional view showing a state immediately after discharge initiation of a forged roughly shaped material in a conventional forging device.

### EMBODIMENTS FOR CARRYING OUT THE INVENTION

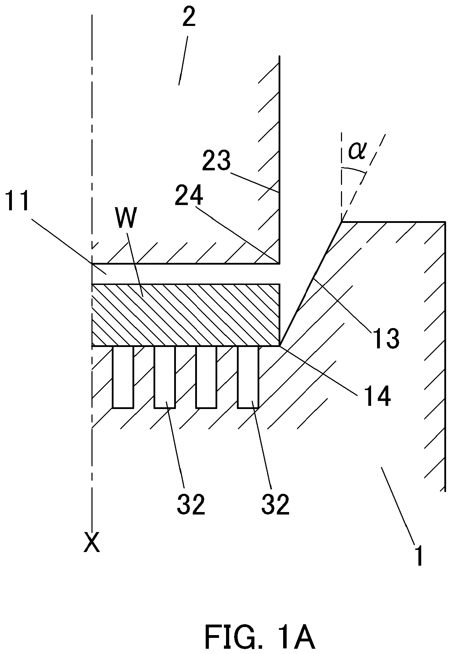

FIG. 1A to FIG. 1E are cross-sectional views showing one side half of a die of a forging device according to a first embodiment not being part of the present invention. In this embodiment, using the forging device shown in these figures, a forging material W is die-forged in a semi-sealed manner to form a heat sink as a forged product.

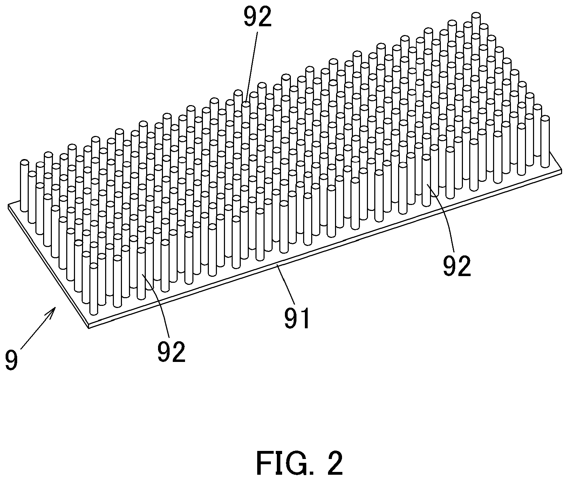

FIG. 2 is a perspective view showing an example of a heat sink 9 produced by the forging device of the embodiment. As shown in the figure, the heat sink 9 is provided with a rectangular base plate 91 and a large number of fins (pin fins) 92 integrally formed on one surface of the base plate 91.

As shown in FIG. 1A to FIG. 1E, the forging device of this embodiment is provided with a die (lower die) 1 and a punch (upper die) 2.

The die 1 is provided with a molding hole 11 recessed downward on its upper surface side. On the bottom surface of this molding hole 11, a large number of fin molding cavities 32 for forming fins 92 as protrusions are provided.

Further, the inner peripheral side surface 13 of the die 1 is formed in an inclined surface which is inclined with respect to the axis X and gradually approaches the axis X toward the pressing direction (downward direction) by the punch 2, in other words, toward the inner portion of the molding hole 11. In this embodiment, as shown in FIG. 1A, the inclination angle α of the molding hole inner peripheral side surface 13 with respect to the axis X is set to 0.1° to 20°.

In this embodiment, although the molding hole inner peripheral side surface 13 is formed in a straight line in cross-section, it is not always necessary to form it in a straight line in cross-section. The molding hole inner peripheral side surface is not necessarily formed in a straight shape in cross-section but may be formed in a slightly bent arc shape in cross-section or a slightly bent polygonal shape in cross-section or the like. Such cases are also included in the present invention.

In this embodiment, the lower end outer peripheral edge portion of the molding hole inner peripheral side surface 13 of the die 1, in other words, the entire circumference of the corner portion between the bottom surface of the molding hole 11 and the inner peripheral side surface 13, forms an internal corner portion 14.

The punch 2 is arranged so that the axis thereof coincides with the axis of the die 1, and is configured to be vertically movable up and down, so that the tip end portion of the punch 2 is driven into the molding hole 11 of the die 1 with a predetermined load.

In this embodiment, the tip end portion of the punch 2 denotes a portion which is to be accommodated in the molding hole 11 when the punch 2 is driven into the die 1.

In this embodiment, the tip end surface outer peripheral edge portion of the punch 2, in other words, the entire circumference of the corner portion between the tip end surface of the punch 2 and the outer peripheral side surface 23, forms the external corner portion 24.

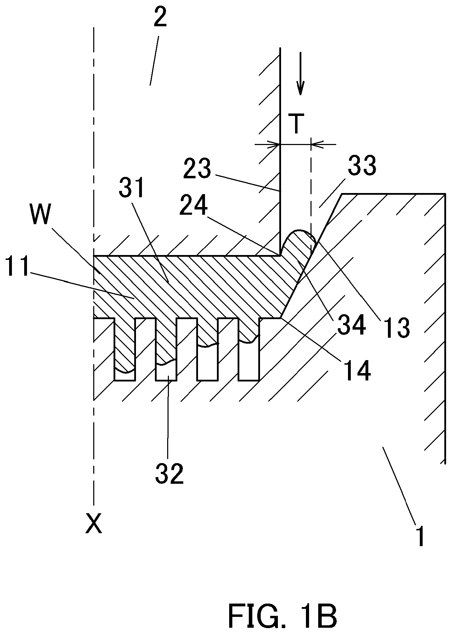

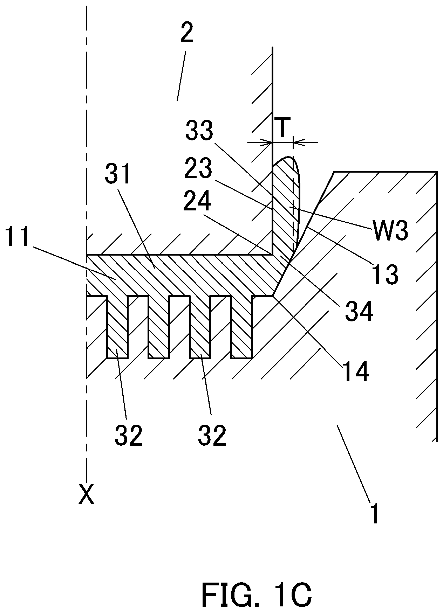

In the forging device having the configuration of this embodiment, as shown in FIG. 1B, FIG. 1C, etc., when the punch 2 is driven into the die 1, between the bottom surface of the molding hole 11 of the die 1 and the tip end surface (pressurizing surface) of the punch 2, a base plate molding portion 31 for molding the base plate 91 of the heat sink 9 is formed, and between the inner peripheral side surface 13 of the molding hole 11 of the die 1 and the outer peripheral side surface 23 of the punch 2, a burr molding portion 33 for molding a burr is formed. This burr molding portion 33 is open to the outside.

In this embodiment, between the tip end surface outer peripheral edge portion (external corner portion) 24 and the inner peripheral side surface 13 of the molding hole 11, a burr molding portion inlet 34 is formed. As shown in FIG. 1B and FIG. 1C, in this embodiment, the width T of this burr molding portion inlet 34 corresponds to the horizontal dimension between the external corner portion 24 of the punch 2 and the molding hole inner peripheral side surface.

In the case of performing a forging process using the forging device having the aforementioned configuration, as shown in FIG. 1A, a forging material W is put in the molding hole 11 of the die 1.

As the forging material W, those made of an aluminum alloy or a copper alloy are preferably used. In this embodiment, a plate material is used as a forging material W. For example, this plate material may be produced by cutting a rolled material by trimming or machining, or may be produced by cutting a flat bar shaped extrusion material or cutting a rectangular continuous cast bar. Needless to say, the forging material W is formed to have a size and a shape capable of being accommodated in the molding hole 11 of the die 1.

The forging material W to be input is subjected to a lubrication treatment as necessary and heated to about 400°C to 600°C, and dies, such as, e.g., the die 1 and the punch 2, are also subjected to a lubrication treatment as necessary and heated. Needless to say, in the case of cold forging, the forging material W and the die are not heated.

After setting the forging material W in the molding hole 11, the punch 2 is lowered to press the forging material W. As shown in FIG. 1B, in the state immediately after initiation of the pressurization against the forging material W with the punch 2, the metallic material (metal) constituting the forging material W is divided into the metal flowing toward the center (radially inward direction) and the metal flowing toward the outer side (radially outward direction) by the split flow forging effect. Among them, by the metal flowing toward the center, the fin molding cavities 32 at the center portion are filled sufficiently. On the other hand, since the molding hole inner peripheral side surface 13 is formed in an inclined surface, at the stage in which the tip end portion of the punch 2 immediately after initiation of the pressurization has not been completely driven into the molding hole 11, the width T of the burr molding portion inlet 34 between the external corner portion 24 of the punch 2 and the molding hole inner peripheral side surface 13 is sufficiently wide. For this reason, a large amount of metal toward the outside smoothly flows toward the burr molding portion 33, and therefore the metal is efficiently discharged from the base plate molding portion 31 between the punch tip end surface and the molding hole bottom surface to the burr molding portion 33. Thus, the vertical dimension of the base plate molding portion 31 can be formed sufficiently small.

In this way, at the initial stage of pressurization, the metal toward the outside actively flows toward the burr molding portion 33. Therefore, the filling amount of the metal to the fin molding cavities 32 on the outer side is smaller than the metal filling amount of the fin molding cavities 32 at the center portion.

However, as the molding progresses, the width T of the burr molding portion inlet 34 between the external corner portion 24 of the punch 2 and the molding hole inner peripheral side surface 13 gradually narrows as the punch 2 descends. In the state immediately before completion of pressurization, as shown in FIG. 1C, the metal toward the outside is suppressed from flowing into the burr molding portion 33, which promotes the inflow to the fin molding cavities 32 on the outer side. In this way, the fin molding cavities 32 on the outer side are also sufficiently filled with the metal, and therefore all the fin molding cavities 32 in the center and outside are sufficiently filled with the metal. Thus, a forged roughly shaped material for a heat sink is molded.

In the present invention, a back pressure forging in which the bottom surface portion of the fin molding cavity 32 is constituted by a movable back pressure pin so that resistance (back pressure) in the direction opposite to the inflow direction is imparted to the metal flowing into the fin molding cavity 32 may be adopted.

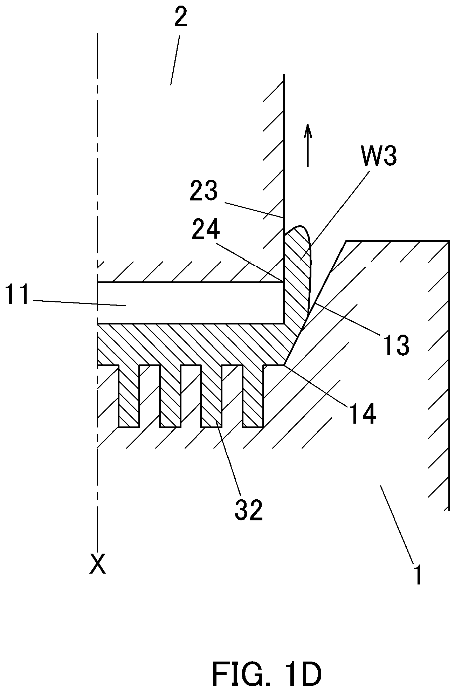

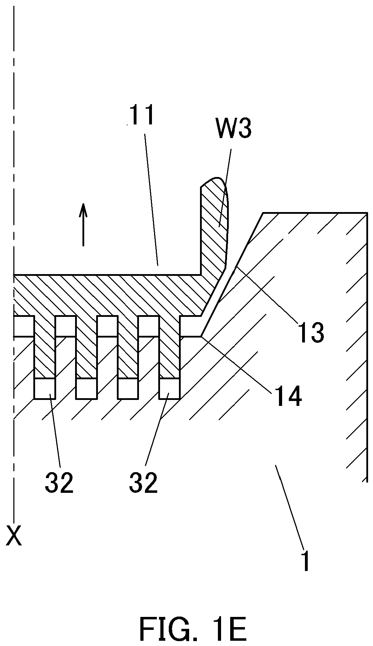

On the other hand, as shown in FIG. 1D, upon completion of the pressurization by the punch 2 (completion of molding), after the punch 2 is raised and returned to the initial position, as shown in FIG. 1E, the forged roughly shaped material is pushed upward from the molding hole 11 and discharged by knockout pins (not shown).

In the forged roughly shaped material molded as described above, burrs are removed by trim processing. After that, the formed forged roughly shaped material is subj ected to machining and washing as necessary and finished as a heat sink 9 as a forged product as shown in FIG. 2.

As described above, according to the forging device of this embodiment, since the molding hole inner peripheral side surface 13 of the die 1 is formed in an inclined surface that expands toward upward, as the punch 2 descends as the forming progresses, the width T of the burr molding portion inlet 34 on the way from the base plate molding portion 31 to the burr molding portion 33 gradually narrows. For this reason, at the initial stage of pressurization, the metal flows preferentially to the fin molding cavities 32 at the center portion and the burr molding portion 33, so it is possible to form the vertical dimension (thickness) of the base plate molding portion 31 as thin as desired. Further, at the final stage of the molding, the width T of the burr molding portion inlet 34 narrows, so that the flow of the metal toward the burr molding portion 33 is suppressed. For this reason, the metal is sufficiently filled also in the fin molding cavities 32 at the outer peripheral portion, so that the metal is sufficiently filled in all of the fin molding cavities 32, which can effectively prevent occurrence of underfill.

Accordingly, all fin heights of the heat sink 9 as a forged product can be precisely matched, and a high quality forged product can be produced.

Furthermore, since the thickness of the base plate molding portion 31 can be made thin, the base plate 91 of the heat sink 9 as a forged product can be formed thin, so that the heat sink 9 can be reduced in weight and size.

Further, in this embodiment, since the molding hole inner peripheral side surface 13 of the die 1 is formed in an inclined surface, it is possible to reduce the load (forging load) by the punch 2.

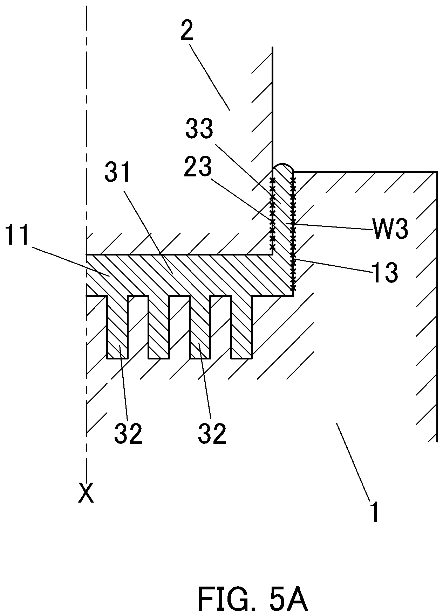

That is, in a conventional forging device, as shown in FIG. 5A, the inner peripheral side surface 13 of the molding hole 11 of the die 1 and the outer peripheral side surface 23 of the punch 2 are both formed by vertical planes, and the width of the burr molding portion 33 constituted by and between these side surfaces 13 and 23 is formed constant regardless of the vertical position. Therefore, the metal flowing from the base plate molding portion 31 into the burr molding portion 33 is filled into the burr molding portion 33 while being in surface contact with the molding hole inner peripheral side surface 13 and the punch outer peripheral side surface 23. For this reason, the flow resistance of the metal flowing through the burr molding portion 33 increases, so that it is necessary to increase the punch load accordingly. As a result, it is necessary to enlarge the press machine, which may cause an increased weight of the forging device .

In contrast, in this embodiment, as shown in FIG. 1C, the molding hole inner peripheral side surface 13 is formed in an inclined surface. Therefore, the metal flowing from the base plate molding portion 31 to the burr molding portion 33 only makes line contact with the external corner portion 24 of the punch 2 and is hardly subjected to the surface contact resistance to the molding hole inner peripheral side surface 13 and the punch outer peripheral side surface 23. Therefore, the flow resistance of the metal flowing through the burr molding portion 33 decreases, and the punch load can be reduced accordingly. As a result, it is possible to reduce the size and weight of the forging device itself, and it is possible to produce a large forged product large in projection area with a small compact machine of a press machine. Furthermore, since the flow resistance of the metal flowing through the burr molding portion 33 is small, it is possible to increase the discharge amount of the metal from the base plate molding portion 31 to the burr molding portion 33, which in turn can assuredly reduce the thickness of the base plate molding portion 31. Thus, the thickness of the base plate 91 in the forged product can be more assuredly formed to be thin.

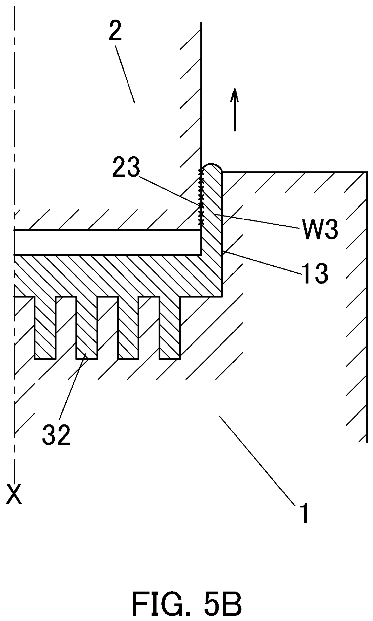

As shown in FIG. 5A, in a conventional forging device, the contact area and the contact pressure between the burr W3 of the forged roughly shaped material and the punch outer peripheral side surface 23 are large. As shown in FIG. 5B, when raising the punch 2 after pressurization, the releasability of the punch 2 to the forged roughly shaped material (burr W3) is bad, which prevents the smooth forging process operation. Therefore, there is a possibility of causing deterioration of the productivity.

In contrast, in this embodiment, as shown in FIG. 1C, the contact area and the contact pressure between the burr W3 of the forged roughly shaped material and the punch outer peripheral side surface 23 are smaller than those of the conventional forging device shown in FIG. 5A. Therefore, as shown in FIG. 1D, when raising the punch 2 after pressurization, the releasability of the punch 2 with respect to the forged roughly shaped material (burr W3) is good, enabling the smooth forging process operation, which can improve the productivity.

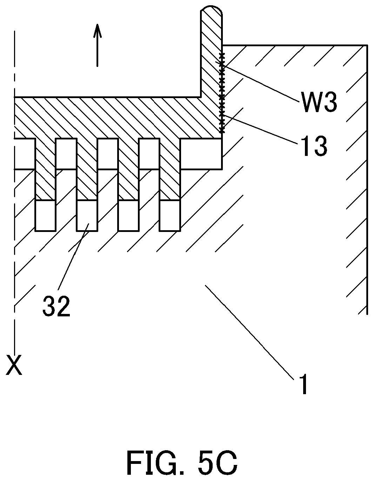

Further, as shown in FIG. 5C, in the conventional forging device, the molding hole inner peripheral side surface 13 is formed vertically. For this reason, it is difficult to discharge the forged roughly shaped material from the molding hole 11 due to the influence of the contact resistance of the burr W3 to the molding hole inner peripheral side surface 13 at the time of pushing out the forged roughly shaped material from the molding hole 11 after molding. In some cases, harmful deformation such as bending deformation may occur in the forged roughly shaped material. From this point as well, the forging process operation cannot be performed smoothly, which may sometimes cause deterioration of the productivity.

On the other hand, as shown in FIG. 1E, in the forging device of this embodiment, the molding hole inner peripheral side surface 13 is formed in an inclined surface. For this reason, when the forged roughly shaped material is slightly raised after molding, the contact resistance of the burr W3 to the molding hole inner peripheral side surface 13 disappears. Therefore, the forged roughly shaped material can be discharged from the molding hole 11 without difficulty, which can assuredly prevent occurrence of harmful bending deformation, etc., and also can perform the forging process more smoothly. Thus, the productivity can be further improved.

### <Examples and Comparative Examples>

A forging device similar to the forging device of the first embodiment shown in FIG. 1A to FIG. 1E was prepared. At this time, a die 1 and a punch 2 were prepared under the conditions of producing a heat sink in which columnar pin fins 92 each having a pin diameter ϕ of 2.2 mm and a height of 10 mm were formed in a staggered arrangement manner on one surface side of the base plate 91, a distance (distance between pin outer diameters) between adjacent pin fins 92 was 0.9 mm, the number of pins was 13 × 40, a total of 520.

In the forging device, a die 1 was prepared in which the inclination angle α of the molding hole inner peripheral side surface 13 was 10° . Note that the tip end portion outer peripheral side surface 23 of the punch 2 was a vertical plane with an inclination angle of 0°.

As a forging material W, a 1,000 series aluminum alloy was prepared. As this material W, a material formed by cutting an extrusion material (flat bar) with a width of 50 mm × a thickness of 4 mm was cut into 80 mm was prepared. The material W has been adjusted to fit the molding hole 11 of the die 1.

Then, the dies, such as the die 1 and the punch 2, of the forging device was heated to 200°C or higher, lubricant was directly sprayed onto the dies immediately before forging process, and then the forging material W was put in a molding hole 11 of the die 1. Note that the forging material W which was pre-heated to 500°C without performing a lubrication treatment was used.

After setting the forging material W in the forging device as described above, a forging process was performed in the same manner as in the first embodiment to produce the forged product (heat sink) of an example. In the obtained forged product (heat sink), the thickness of the base plate 91 was made as thin as about 0.3 mm. Furthermore, the variation in the pin height could be controlled to 0.5 mm or less, and the pin heights could be matched without problems. In addition, defects, such as bent deformation which is harmful to the forged product, were not particularly recognized.

On the other hand, except that a forging device similar to the conventional forging device shown in FIG. 5A to FIG. 5C was used, that is, except that a forging device in which the molding hole inner peripheral side surface 13 of the die 1 is a vertical plane of an inclination angle 0° was used, a forged product (heat sink) was produced in the same manner as in the aforementioned example. In the obtained forged product, the thickness of the base plate 91 could not be controlled to 1 mm or less, and the variation in the pin height was also 0.5 mm or more, so that the pin heights could not be aligned. Further, at the time of taking out the forged roughly shaped material from the die 1, some forged roughly shaped materials had harmful bending deformation.

As will be apparent from the aforementioned examples and comparative examples, according to the forging device of the present invention, the thickness of the base plate 91 could be made thin, and a high quality heat sink 9 with matched pin heights could be manufactured.

### <Second Embodiment>

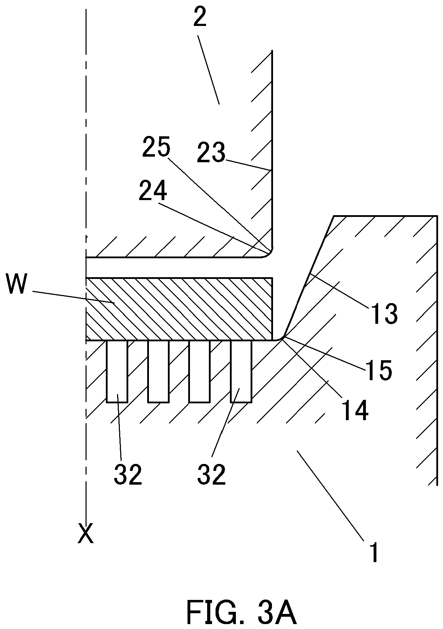

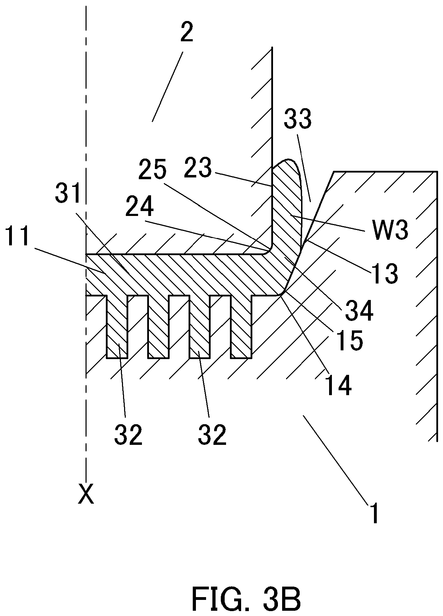

FIG. 3A and FIG. 3B are cross-sectional views each showing a forging device according to a second embodiment not being part of the present invention. As shown in both figures, in this forging device of the second embodiment, a chamfered portion 15 is formed at the internal corner portion 14 of the lower end of the molding hole in the die 1. In this embodiment, the chamfered portion 15 is constituted by an R-plane. By this chamfered portion 15, the portion from the inner peripheral side surface 13 to the bottom surface of the molding hole 11 is formed as a smooth continuous surface.

Further, a chamfered portion 25 is formed at the external corner portion 24 of the tip end surface outer peripheral edge portion of the punch 2. In this embodiment, the chamfered portion 25 is constituted by an R-plane. By this chamfered portion 25, the portion from the outer peripheral side surface 23 of the punch 2 to the tip end surface is formed into a smooth continuous surface.

In this forging device of this second embodiment, since the other configuration is substantially the same as that of the forging device of the first embodiment, the same or equivalent parts are allotted by the same reference numerals, and the redundant description will be omitted.

Also in this forging device of the second embodiment, the same effect as that of the forging device of the first embodiment can be obtained.

Furthermore, in the second forging device, the chamfered portions 15 and 25 are formed at the internal corner portion 14 of the molding hole lower end outer peripheral edge portion of the die 1 and the external corner portion 24 of the tip end surface outer peripheral edge portion of the punch 2, respectively. Therefore, the internal corner portion 14 and the external corner portion 24 each are not formed in a sharp edge shape, so the durability can be improved. That is, if the internal corner portion 14 of the die 1 and the external corner portion 24 of the punch 2 each are formed into a sharp edge, stress concentrates on the internal corner portion 14 and the external corner portion 24 when the punch 2 is driven. In such a case, cracks tend to occur in the internal corner portion 14 of the die 1 and the external corner portion 24 of the punch 2, so that the die life becomes short and the durability may deteriorate.

In view of the above, in the second embodiment, the chamfered portions 15 and 25 are formed in the internal corner portion 14 of the die 1 and the external corner portion 24 of the punch 2, respectively, the internal corner portion 14 and the external corner portion 24 each have a smooth shape, so it is possible to prevent local concentration of the stress on the internal corner portion 14 and the external corner portion 24 at the time of driving the punch. For this reason, it is possible to effectively prevent occurrence of cracks in the internal corner portion 14 of the die 1, the external corner portion 24 of the punch 2, etc., so that the die life can be extended and the durability can be improved.

Furthermore, in this forging device of the second embodiment, since the chamfered portion 25 is formed at the external corner portion 24 of the punch 2, it is possible to assuredly prevent such a trouble that the external corner portion 24 of the punch 2 comes into contact with the inner peripheral side surface 13 of the molding hole 11 of the die 1, which can assuredly prevent damage of the due to the contact.

Furthermore, in this forging device of the second embodiment, since the chamfered portions 15 and 25 are each formed in the internal corner portion 14 of the molding hole 11 and the external corner portion 24 of the punch 2, the burr molding portion inflow passage from the base plate molding portion 31 to the burr molding portion inlet 34 is formed by a gently curved circular arc flow passage rather than a bent flow passage that rapidly changes in direction. For this reason, the flow of the metal from the base plate molding portion 31 to the burr molding portion 33 can be performed smoothly during the molding, which can further reduce the punch load. This in turn can further miniaturize the forging device.

Note that in this second embodiment, the chamfered portions 15 and 25 of the internal corner portion 14 of the molding hole 11 and the external corner portion 24 of the punch 2 are formed by an R-plane, but the present invention is not limited to this. In the present invention, the internal corner portion 14 and the external corner portion 24 may be each formed by a C-plane or multiple planes.

### <Third Embodiment>

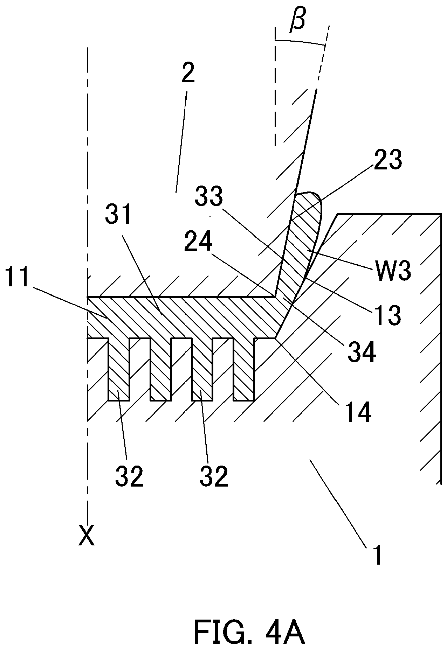

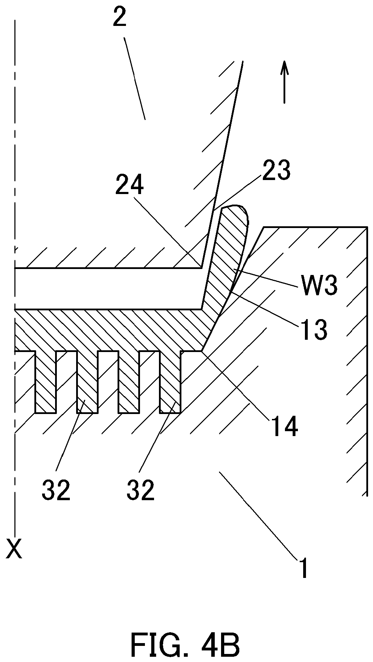

FIG. 4A and FIG. 4B are cross-sectional views each showing a forging device according to a third embodiment, which is part of the present invention. As shown in these figures, in the forging device of this third embodiment, the tip end portion outer peripheral side surface 23 of the punch 2 is formed in an inclined surface which is inclined with respect to the axis X and gradually approaches the axis X toward the pressing direction (downward direction). In this embodiment, the inclination angle β of the punch outer peripheral side surface 23 with respect to the axis X is set to 0.1° to 20°. The inclination angle β of the punch outer peripheral surface 23 is equal to or smaller than the inclination angle α of the molding hole inner peripheral side surface 13 shown in FIG. 1A.

In this embodiment, although the punch outer peripheral side surface 23 is formed in a straight line in cross-section, it is not always necessary to form it in a straight line in cross-section. The punch outer peripheral side surface 23 is not necessarily formed in a straight shape in cross-section, but may be formed in a slightly bent arc shape in cross-section or a slightly bent polygonal shape in cross-section or the like. Such cases are also included in the present invention.

Further, the position of the tip end surface outer peripheral edge portion (external corner portion) 24 of the punch 2 is arranged at a position closer to the axis X than the position of the molding hole lower end inner peripheral edge portion (internal corner portion) 14 of the die 1.

In this third forging device, since the other configuration is substantially the same as that of the forging device of the first embodiment, the same or equivalent parts are allotted by the same reference numerals, and the redundant description will be omitted.

The third embodiment of the forging device can also obtain the same effects as those of the aforementioned first forging device.

Furthermore, in the forging device of the third embodiment, since the tip end portion outer peripheral side surface 23 of the punch 2 is formed in the inclined surface, as shown in FIG. 4B, at the time when the punch 2 is raised slightly after pressurization, the contact of the punch 2 to the burr W3 is released and the whole area is separated. For this reason, at the time of rising the punch 2, the punch 2 can be separated without difficulty from the forged roughly shaped material, enabling a more smooth forging process operation, which further can improve the production efficiency.

Furthermore, in the forging device of this third embodiment, since the external corner portion 24 of the punch 2 is arranged inner than the internal corner portion 14 of the molding hole 11, it is possible to more assuredly prevent the external corner portion 24 of the punch 2 from coming into contact with the inner peripheral side surface of the molding hole 11 of the die 1, which in turn can more assuredly prevent breakage of the due to the contact.

In each of the above-described embodiments, the case in which the fin molding cavities 32 are formed on the die 1 side has been described as an example, but the present invention is not limited thereto. In the present invention, fin molding cavities may be formed on the punch side, or a heat sink (forged product) in which fins are formed on both surfaces of the base plate may be formed by forming fin molding cavities on both the die side and the punch side.

Further, in the above-described embodiments, the case in which the heat sink having pin fins formed on the base plate is described as an example, but the present invention is not limited thereto. The present invention can also be applied to the case of forming a heat sink having plate fins formed on one or both sides of the heat sink.

Further, in the above-described embodiments, the case in which the heat sink is formed by the present invention has been described as an example, but the present invention is not limited to such a heat sink. The present invention can be adopted in the case of producing a forged product in which a plurality of protrusions is formed on at least one surface of a base plate.

Further, in the above-described embodiments, the position of the external corner portion 24 of the punch 2 from the axis X is set to be equal to or inner than the position of the internal corner portion 14 of the die molding hole 11 from the axis X, in other words, the horizontal distance of the external corner portion 24 of the punch 2 from the axis X is set to be equal to or shorter than the horizontal distance of the internal corner portion 14 of the die molding hole 11 from the axis X. However, the present invention is not limited to it, and the position of the punch external corner portion 24 may be arranged outside the die molding hole internal corner portion 14.

While illustrative embodiments of the invention have been described herein, the present invention is not limited to the various preferred embodiments described herein, but includes any and all embodiments having equivalent elements, modifications, omissions, combinations (e.g., of aspects across various embodiments), adaptations and/or alterations as would be appreciated by those in the art based on the present disclosure. Limitations in the claims are to be interpreted broadly based on the language employed in the claims and not limited to examples described in the present specification or during the prosecution of the application, which examples are to be construed as non-exclusive. A number of illustrative embodiments are described herein with the understanding that the present disclosure is to be considered as providing examples of the principles of the invention and such examples are not intended to limit the invention to preferred embodiments described herein and/or illustrated herein.

### Industrial Applicability

The forging device of the present invention can be suitably applied in manufacturing a forged product, such as, e.g., a heat sink in which a large number of fins are formed on a base plate.

### Description of Reference Symbols

- 1:: die(lower die)
- 11:: molding hole
- 13:: inner peripheral side surface
- 14:: internal corner portion
- 15:: chamfered portion
- 2:: punch(upper die)
- 23:: outer peripheral side surface
- 24:: external corner portion
- 25:: chamfered portion
- 31:: base plate molding portion
- 32:: fin molding cavity(protrusion molding cavity)
- 33:: burr molding portion
- 9:: heat sink(forged product)
- 91:: base plate
- 92:: fin(pin fin)
- W:: forging material
- W3:: burr
- X:: axis
- α:: inclination angle of the molding hole inner peripheral side surface
- β:: inclination angle of the punch tip end portion outer peripheral side surface

## Claims

1. A forging device for producing a forged product in which a protrusion (92) is formed on a base plate (91), comprising:
a die (1) having a molding hole (11); and
a punch (2) to be driven into the molding hole (11), wherein, in use, a protrusion is formed by a protrusion molding cavity (32) formed in at least one of a bottom surface of the molding hole (11) of the die (1) and a tip end surface of the punch (2),
wherein a base plate molding portion (31) is formed between the tip end surface of the punch (2) and the bottom surface of the molding hole (11), and
wherein a burr molding portion (33) is formed between a tip end portion outer peripheral side surface of the punch (2) and an inner peripheral side surface of the molding hole (11),
**characterized in that** the inner peripheral side surface of the molding hole (11) is formed by an inclined surface which is inclined with respect to an axis (X) of the punch (2) substantially parallel to a pressing direction of the punch (2) and approaches the axis (X) toward a pressing direction of the punch (2), and
**in that** the tip end portion outer peripheral side surface of the punch (2) is formed by an inclined surface which is inclined with respect to the axis (X) and approaches the axis (X) toward the pressing direction of the punch (2), and
wherein an inclination angle (β) of the tip end portion outer peripheral side surface of the punch (2) with respect to the axis (X) is formed to be less than an inclination angle (α) of the inner peripheral side surface of the molding hole (11) with respect to the axis (X).

2. The forging device as recited in claim 1,
wherein a chamfered portion (25) is formed at an external corner portion (24) between the tip end portion outer peripheral side surface and the tip end surface of the punch (2).

3. The forging device as recited in any one of claims 1 to 2,
wherein an external corner portion (24) between the tip end portion outer peripheral side surface and the tip end surface of the punch (2) is arranged at a position closer to the axis (X) than the internal corner portion (14) between the inner peripheral side surface and the bottom surface of the molding hole (11).

4. The forging device as recited in any one of claims 1 to 3,
wherein the protrusion molding cavity (32) is constituted by a fin molding cavity for molding a fin of a heat sink (9).

5. The forging device as recited in any one of claims 1 to 4,
wherein a chamfered portion (15) is formed at an internal corner portion (14) between the inner peripheral side surface and the bottom surface of the molding hole (11).

6. A forging method for producing a forged product in which a protrusion (92) is formed on a base plate (91), comprising:
a step of setting a forging material in a molding hole (11) of a die (1); and
a step of pressurizing the forging material by driving the punch (2) into the molding hole (11);
wherein in the step of pressurizing the forging material, a protrusion (92) is formed by a protrusion molding cavity (32) formed on at least one of a bottom surface of the molding hole (11) of the die (1) and a tip end surface of the punch (2),
wherein a base plate (91) is molded by a base plate molding portion (31) formed between the tip end surface of the punch (2) and the bottom surface of the molding hole (11), and
wherein a burr is formed by a burr molding portion (33) formed between a tip end portion outer peripheral side surface of the punch (2) and the inner peripheral side surface of the molding hole (11),
**characterized in that** the die (1) is formed by an inclined surface in which an inner peripheral side surface of a molding hole (11) is inclined with respect to an axis (X) of the punch substantially parallel to a pressing direction of a punch (2) and approaches the axis (X) toward an inner portion of the molding hole (11), and
**in that** the tip end portion outer peripheral side surface of the punch (2) is formed by an inclined surface which is inclined with respect to the axis (X) and approaches the axis (X) toward the pressing direction of the punch (2), and
wherein an inclination angle (β) of the tip end portion outer peripheral side surface of the punch (2) with respect to the axis (X) is formed to be less than an inclination angle (α) of the inner peripheral side surface of the molding hole (11) with respect to the axis (X).

## Patentansprüche

1. Schmiedevorrichtung zur Herstellung eines geschmiedeten Produkts, bei dem ein Vorsprung (92) auf einer Basisplatte (91) gebildet ist, umfassend:
ein Gesenk (1), das ein Formungsloch (11) aufweist; und
einen Stempel (2), der in das Formungsloch (11) getrieben werden soll,
wobei im Gebrauch ein Vorsprung durch einen Vorsprungsformungshohlraum (32) gebildet ist, der in mindestens einer von einer unteren Oberfläche des Formungslochs (11) des Gesenks (1) und einer Spitzenendoberfläche des Stempels (2) gebildet ist,
wobei ein Basisplattenformungsabschnitt (31) zwischen der Spitzenendoberfläche des Stempels (2) und der unteren Oberfläche des Formungslochs (11) gebildet ist, und
wobei ein Gratformungsabschnitt (33) zwischen einer äußeren umlaufenden Seitenoberfläche des Spitzenendabschnitts des Stempels (2) und einer inneren umlaufenden Seitenoberfläche des Formungslochs (11) gebildet ist,
**dadurch gekennzeichnet, dass** die innere umlaufende Seitenoberfläche des Formungslochs (11) durch eine geneigte Oberfläche gebildet ist, die in Bezug auf eine Achse (X) des Stempels (2) im Wesentlichen parallel zu einer Pressrichtung des Stempels (2) geneigt ist und sich der Achse (X) in Richtung einer Pressrichtung des Stempels (2) nähert, und
dass die äußere umlaufende Seitenoberfläche des Spitzenendabschnitts des Stempels (2) durch eine geneigte Oberfläche gebildet ist, die in Bezug auf die Achse (X) geneigt ist und sich der Achse (X) in Richtung der Pressrichtung des Stempels (2) nähert, und
wobei ein Neigungswinkel (β) der äußeren umlaufenden Seitenoberfläche des Spitzenendabschnitts des Stempels (2) in Bezug auf die Achse (X) kleiner gebildet ist als ein Neigungswinkel (α) der inneren umlaufenden Seitenoberfläche des Formungslochs (11) in Bezug auf die Achse (X).

2. Schmiedevorrichtung nach Anspruch 1,
wobei ein abgeschrägter Abschnitt (25) an einem äußeren Eckabschnitt (24) zwischen der äußeren umlaufenden Seitenoberfläche des Spitzenendabschnitts und der Spitzenendoberfläche des Stempels (2) gebildet ist.

3. Schmiedevorrichtung nach einem der Ansprüche 1 bis 2,
wobei ein externer Eckabschnitt (24) zwischen der äußeren umlaufenden Seitenoberfläche des Spitzenendabschnitts und der Spitzenendoberfläche des Stempels (2) an einer Position angeordnet ist, die näher an der Achse (X) liegt als der innere Eckabschnitt (14) zwischen der inneren umlaufenden Seitenoberfläche und der unteren Oberfläche des Formungslochs (11).

4. Schmiedevorrichtung nach einem der Ansprüche 1 bis 3,
wobei der Vorsprungsformungshohlraum (32) durch einen Rippenformungshohlraum zum Formen einer Rippe einer Wärmesenke (9) gebildet ist.

5. Schmiedevorrichtung nach einem der Ansprüche 1 bis 4,
wobei ein abgeschrägter Abschnitt (15) an einem inneren Eckabschnitt (14) zwischen der inneren umlaufenden Seitenoberfläche und der unteren Oberfläche des Formungslochs (11) gebildet ist.

6. Schmiedevorrichtung zur Herstellung eines geschmiedeten Produkts, bei dem ein Vorsprung (92) auf einer Basisplatte (91) gebildet ist, umfassend:
einen Schritt des Einsetzens eines Schmiedematerials in ein Formungsloch (11) eines Gesenks (1); und
einen Schritt der Pressung des Schmiedematerials durch Treiben des Stempels (2) in das Formungsloch (11);
wobei in dem Schritt der Pressung des Schmiedematerials ein Vorsprung (92) durch einen Vorsprungsformungshohlraum (32) gebildet wird, der an mindestens einer von einer unteren Oberfläche des Formungslochs (11) des Gesenks (1) und einer Spitzenendoberfläche des Stempels (2) gebildet ist,
wobei eine Basisplatte (91) durch einen Basisplattenformungsabschnitt (31), der zwischen der Spitzenendoberfläche des Stempels (2) und der unteren Oberfläche des Formungslochs (11) gebildet ist, geformt wird, und
wobei ein Grat durch einen Gratformungsabschnitt (33) gebildet wird, der zwischen einer äußeren umlaufenden Seitenoberfläche des Spitzenendabschnitts des Stempels (2) und der inneren umlaufenden Seitenoberfläche des Formungslochs (11) gebildet ist,
**dadurch gekennzeichnet, dass** das Gesenk (1) durch eine geneigte Oberfläche gebildet ist, bei der eine innere umlaufende Seitenoberfläche eines Formungslochs (11) in Bezug auf eine Achse (X) des Stempels im Wesentlichen parallel zu einer Pressrichtung eines Stempels (2) geneigt ist und sich der Achse (X) in Richtung eines inneren Abschnitts des Formungslochs (11) nähert, und
dass die äußere umlaufende Seitenoberfläche des Spitzenendabschnitts des Stempels (2) durch eine geneigte Oberfläche gebildet ist, die in Bezug auf die Achse (X) geneigt ist und sich der Achse (X) in Richtung der Pressrichtung des Stempels (2) nähert, und
wobei ein Neigungswinkel (β) der äußeren umlaufenden Seitenoberfläche des Spitzenendabschnitts des Stempels (2) in Bezug auf die Achse (X) kleiner gebildet ist als ein Neigungswinkel (α) der inneren umlaufenden Seitenoberfläche des Formungslochs (11) in Bezug auf die Achse (X).

## Revendications

1. Dispositif de forgeage pour produire un produit forgé dans lequel une saillie (92) est formée sur une plaque de base (91), comprenant :
une matrice (1) présentant un trou de moulage (11) ; et
un poinçon (2) à enfoncer dans le trou de moulage (11),
dans lequel, en utilisation, une saillie est formée par une cavité de moulage de saillie (32) formée dans au moins l'une d'une surface inférieure du trou de moulage (11) de la matrice (1) et d'une surface d'extrémité de pointe du poinçon (2),
dans lequel une partie de moulage de plaque de base (31) est formée entre la surface d'extrémité de pointe du poinçon (2) et la surface inférieure du trou de moulage (11), et
dans lequel une partie de moulage de bavure (33) est formée entre une surface latérale périphérique extérieure de partie d'extrémité de pointe du poinçon (2) et une surface latérale périphérique intérieure du trou de moulage (11),
**caractérisé en ce que** la surface latérale périphérique intérieure du trou de moulage (11) est formée par une surface inclinée qui est inclinée par rapport à un axe (X) du poinçon (2) sensiblement parallèle à une direction de pressage du poinçon (2) et s'approche de l'axe (X) vers une direction de pressage du poinçon (2), et
**en ce que** la surface latérale périphérique extérieure de partie d'extrémité de pointe du poinçon (2) est formée par une surface inclinée qui est inclinée par rapport à l'axe (X) et s'approche de l'axe (X) vers la direction de pressage du poinçon (2), et
dans lequel un angle d'inclinaison (β) de la surface latérale périphérique extérieure de partie d'extrémité de pointe du poinçon (2) par rapport à l'axe (X) est formé pour être inférieur à un angle d'inclinaison (α) de la surface latérale périphérique intérieure du trou de moulage (11) par rapport à l'axe (X).

2. Dispositif de forgeage selon la revendication 1,
dans lequel une partie chanfreinée (25) est formée au niveau d'une partie de coin externe (24) entre la surface latérale périphérique externe de partie d'extrémité de pointe et la surface d'extrémité de pointe du poinçon (2).

3. Dispositif de forgeage selon l'une quelconque des revendications 1 à 2,
dans lequel une partie de coin externe (24) entre la surface latérale périphérique externe de la partie d'extrémité de pointe et la surface d'extrémité de pointe du poinçon (2) est agencée au niveau d'une position plus proche de l'axe (X) que la partie de coin interne (14) entre la surface latérale périphérique interne et la surface inférieure du trou de moulage (11).

4. Dispositif de forgeage selon l'une quelconque des revendications 1 à 3,
dans lequel la cavité de moulage de saillie (32) est constituée par une cavité de moulage d'ailette pour mouler une ailette d'un dissipateur thermique (9).

5. Dispositif de forgeage selon l'une quelconque des revendications 1 à 4,
dans lequel une partie chanfreinée (15) est formée au niveau d'une partie de coin interne (14) entre la surface latérale périphérique interne et la surface inférieure du trou de moulage (11).

6. Procédé de forgeage pour produire un produit forgé dans lequel une saillie (92) est formée sur une plaque de base (91), comprenant :
une étape consistant à placer un matériau de forgeage dans un trou de moulage (11) d'une matrice (1) ; et
une étape consistant à mettre sous pression le matériau de forgeage en enfonçant le poinçon (2) dans le trou de moulage (11) ;
dans lequel, dans l'étape de mise sous pression du matériau de forgeage, une saillie (92) est formée par une cavité de moulage de saillie (32) formée sur au moins l'une d'une surface inférieure du trou de moulage (11) de la matrice (1) et d'une surface d'extrémité de pointe du poinçon (2),
dans lequel une plaque de base (91) est moulée par une partie de moulage de plaque de base (31) formée entre la surface d'extrémité de pointe du poinçon (2) et la surface inférieure du trou de moulage (11), et
dans lequel une bavure est formée par une partie de moulage de bavure (33) formée entre une surface latérale périphérique extérieure de partie d'extrémité de pointe du poinçon (2) et la surface latérale périphérique intérieure du trou de moulage (11),
**caractérisé en ce que** la matrice (1) est formée par une surface inclinée dans laquelle une surface latérale périphérique intérieure d'un trou de moulage (11) est inclinée par rapport à un axe (X) du poinçon sensiblement parallèle à une direction de pressage d'un poinçon (2) et s'approche de l'axe (X) vers une partie intérieure du trou de moulage (11), et
**en ce que** la surface latérale périphérique extérieure de partie d'extrémité de pointe du poinçon (2) est formée par une surface inclinée qui est inclinée par rapport à l'axe (X) et s'approche de l'axe (X) vers la direction de pressage du poinçon (2), et
dans lequel un angle d'inclinaison (β) de la surface latérale périphérique extérieure de partie d'extrémité de pointe du poinçon (2) par rapport à l'axe (X) est formé pour être inférieur à un angle d'inclinaison (a) de la surface latérale périphérique intérieure du trou de moulage (11) par rapport à l'axe (X).
